# EUROPÄISCHE PATENTSCHRIFT

(11) **EP 3 900 124 B1**
(45) Veröffentlichungstag und Bekanntmachung des Hinweises auf die Patenterteilung: **10.01.2024**
(21) Anmeldenummer: 19794473.9
(22) Anmeldetag: 22.10.2019
(51) Int. Cl.: H01R 43/24, H01R 13/405, H01R 13/52, H01R 13/41, H01R 43/00, H05K 5/06

(54) **VERFAHREN ZUM ABDICHTEN EINES STECKERPINS IN EINEM GEHÄUSE UND GEHÄUSEVORRICHTUNG**
METHOD FOR SEALING A PLUG PIN IN A HOUSING, AND HOUSING DEVICE
PROCÉDÉ D'ÉTANCHÉIFICATION D'UNE BROCHE DE CONNEXION DANS UN BOÎTIER ET DISPOSITIF BOÎTIER

(30) Priorität: 18.12.2018 DE 102018222121
(43) Veröffentlichungstag der Anmeldung: 27.10.2021
(73) Patentinhaber: Robert Bosch GmbH, 70442 Stuttgart (DE)
(72) Erfinder: RIETHMUELLER, Bernd, 70469 Stuttgart (DE); MARTIN, Hagen, 99830 Treffurt (DE)
(86) Internationale Anmeldenummer: PCT/EP2019/078673
(87) Internationale Veröffentlichungsnummer: WO 2020/126159

(56) Entgegenhaltungen:
- JP-A- H06 203 903
- JP-A- 2012 059 624
- US-A1- 2018 261 951

## Beschreibung

### Gebiet der Erfindung

Die Erfindung betrifft ein Verfahren zum Abdichten eines Steckerpins in einem Gehäuse und eine Gehäusevorrichtung.

### Stand der Technik

Sogenanntes "Stitchen" ist als ein kostengünstiges Verfahren zur Einbringung von Steckerpins in ein Gehäuse als Alternative zu ummoldeten Steckerpins bekannt. Steckerpins werden derart ein Gehäuse eingebracht, dass der Steckerpin nur in zwei zueinander gegenüberliegenden Randbereichen des Steckerpins das Gehäuse kontaktiert und nur in diesen Randbereichen eine formschlüssige Verbindung mit dem Gehäuse bildet. Oberhalb des Steckerpins und unterhalb des Steckerpins verbleibt ein offener Zwischenraum, der eine durchlässige Verbindung zwischen der Umgebung und dem Innenraum des Gehäuses bildet.

In einigen Anwendungen, z.B. bei einer Sensorvorrichtung, wird jedoch eine dichte, d.h. für Fluide, insbesondere Gase, nicht-durchlässige, Verbindung zwischen Umgebung und Innenraum des Gehäuses benötigt. Üblicherweise wird hierzu die Einführöffnung von außerhalb des Gehäuses aus mit einer Vergussmasse geschlossen. Alternativ wird an dem Ende des Steckerpins, der dem Innenraum des Gehäuses am nächsten liegt, die Verbindung mit Vergussmaterial verschlossen. Hierbei besteht die Gefahr, dass die Steckerpins mit Vergussmasse benetzt werden und hierdurch die Steckerpins ihre Funktionsfähigkeit einbüßen, d.h. nicht mehr funktionieren. Zudem muss das Vergießen des Zwischenraums vor einem Verschließen des Innenraums des Gehäuses stattfinden, so dass der Bereich um den Steckerpin nicht mehr für eine Entlüftung während des Verschlussprozesses, z.B. beim Aushärten des Vergussmaterials, verwendet werden kann.

Aus der JP H06 203903 A ist eine Gehäusevorrichtung mit den Merkmalen des Oberbegriffs des unabhängigen Anspruchs 5 bekannt. Weitere Gehäusevorrichtungen sind aus der JP 2012 059624 A und der US 2018/261951 A1 bekannt.

### Offenbarung der Erfindung

Vor diesem Hintergrund werden mit dem hier vorgestellten Ansatz ein Verfahren zum Abdichten eines Steckerpins in einem Gehäuse bzw. eine Gehäusevorrichtung gemäß den unabhängigen Ansprüchen vorgestellt. Vorteilhafte Weiterbildungen und Verbesserungen des hier vorgestellten Ansatzes ergeben sich aus der Beschreibung und sind in den abhängigen Ansprüchen beschrieben.

### Vorteile der Erfindung

Ausführungsformen der vorliegenden Erfindung können in vorteilhafter Weise ermöglichen, technisch einfach eine Abdichtung eines Innenraums eines Gehäuses gegenüber der Umgebung in dem Bereich eines in das Gehäuse eingeführten Steckerpins zu erreichen.

Gemäß einem ersten Aspekt der Erfindung wird ein Verfahren zum Abdichten eines Steckerpins in einem Gehäuse vorgeschlagen, wobei das Gehäuse mindestens eine Aussparung zum Abdichten eines Bereichs zwischen dem Steckerpin und dem Gehäuse und eine Aussparung zum Vergießen des Steckerpins aufweist, wobei das Verfahren folgende Schritte umfasst: Bereitstellen des Gehäuses mit dem Steckerpin, wobei der Steckerpin in zwei zueinander gegenüberliegenden entlang einer Einführrichtung verlaufenden Randbereichen des Steckerpins das Gehäuse kontaktiert und in diesen Randbereichen eine formschlüssige Verbindung mit dem Gehäuse bildet; Einbringen von Vergussmasse in die mindestens eine Aussparung derart, dass die Vergussmasse auf zwei gegenüberliegende Seiten des Steckerpins gelangt, dass die Vergussmasse den Bereich zwischen dem Steckerpin und dem Gehäuse , insbesondere flüssigkeitsdicht, vorzugsweise luftdicht, abdichtet und Aushärten der Vergussmasse. Erfindungsgemäß berührt die Vergussmasse die zwei entlang der Einführrichtung gegenüberliegenden Enden des Steckerpins nicht und der Steckerpin weist eine Öffnung zum Gelangen der Vergussmasse von einer Seite des Steckerpins auf die andere Seite des Steckerpins auf, wobei die Öffnung zumindest teilweise fluchtend mit der Aussparung ausgerichtet wird.

Vorteilhaft hieran ist, dass das Gehäuse typischerweise nur eine einzige Öffnung aufweisen muss und die Vergussmasse dennoch technisch einfach auf beide gegenüberliegende Seiten des Steckerpins gelangt. Somit kann das Verfahren in der Regel besonders schnell durchgeführt werden.

Ein Vorteil dieses Verfahrens ist, dass der Bereich des Steckerpins, insbesondere der Zwischenraum zwischen dem Steckerpin und dem Gehäuse, in der Regel technisch einfach abgedichtet werden kann. Die Abdichtung dieses Bereichs kann typischerweise insbesondere nach dem Verschließen des Innenraums des Gehäuses in anderen Bereichen erfolgen, d.h. der vor dem Verschließen mit Vergussmasse vorhandene Zwischenraum zwischen dem Steckerpin und dem Gehäuse kann die durchlässige Verbindung zwischen dem Innenraum und der Umgebung darstellen. Zudem muss der Steckerpin im Allgemeinen nicht vorbehandelt werden, um eine Anhaftung der Vergussmasse an dem Steckerpin zu verbessern.

Gemäß einem zweiten Aspekt der Erfindung wird eine Gehäusevorrichtung umfassend ein Gehäuse und einen Steckerpin vorgeschlagen, wobei der Steckerpin in eine Einführöffnung des Gehäuses entlang einer Einführrichtung derart eingeführt ist, dass der Steckerpin in zwei zueinander gegenüberliegenden Randbereichen des Steckerpins das Gehäuse kontaktiert und in diesen Randbereichen eine formschlüssige Verbindung mit dem Gehäuse bildet, dadurch gekennzeichnet, dass das Gehäuse mindestens eine Aussparung zum Abdichten eines Bereichs zwischen dem Steckerpin und dem Gehäuse aufweist, wobei in der mindestens einen Aussparung und auf zwei gegenüberliegenden Seiten des Steckerpins Vergussmasse derart angeordnet ist, dass der Bereich zwischen dem Steckerpin und dem Gehäuse, insbesondere flüssigkeitsdicht, vorzugsweise luftdicht, abgedichtet ist. Erfindungsgemäß berührt die Vergussmasse die zwei entlang der Einführrichtung gegenüberliegenden Enden des Steckerpins nicht und
der Steckerpin weist eine Öffnung auf, die zumindest teilweise fluchtend mit der Aussparung des Gehäuses ausgerichtet ist und in der Vergussmasse angeordnet ist.

Vorteilhaft hieran ist, dass das Gehäuse typischerweise nur eine einzige Öffnung aufweisen muss und die Vergussmasse dennoch technisch einfach auf beide gegenüberliegende Seiten des Steckerpins gelangt. Somit kann die Gehäusevorrichtung typischerweise technisch besonders einfach und schnell hergestellt werden.

Ein Vorteil hiervon ist, dass der Bereich des Steckerpins, insbesondere der Zwischenraum zwischen dem Steckerpin und dem Gehäuse, in der Regel technisch einfach abgedichtet ist. Die Abdichtung dieses Bereichs kann typischerweise insbesondere nach dem Verschließen des Innenraums des Gehäuses in anderen Bereichen erfolgen, d.h. der vor dem Verschließen mit Vergussmasse vorhandene Zwischenraum zwischen dem Steckerpin und dem Gehäuse kann die letzte durchlässige Verbindung zwischen dem Innenraum und der Umgebung darstellen. Zudem muss der Steckerpin im Allgemeinen nicht vorbehandelt werden, um eine Anhaftung der Vergussmasse an dem Steckerpin zu verbessern.

Ideen zu Ausführungsformen der vorliegenden Erfindung können unter anderem als auf den nachfolgend beschriebenen Gedanken und Erkenntnissen beruhend angesehen werden.

Der Erfindung liegt die Aufgabe zu Grunde, mindestens eine Öffnung in einem Gehäuse eines Bauelements vorzusehen, wobei durch die Öffnung des Gehäuses ein Vergussmaterial zum luftdichten Verschließen eines Zwischenraums zwischen einem Steckerpin zum elektrischen Verbinden und dem Gehäuse eingebracht werden kann.

Gemäß einer Ausführungsform des Verfahrens weist die Öffnung einen ellipsenförmigen, insbesondere kreisförmigen, oder rechteckigen Querschnitt auf. Hierdurch kann die Öffnung typischerweise technisch einfach hergestellt werden. Zudem weist der Steckerpin in der Regel eine hohe mechanische Belastungsfähigkeit auf.

Gemäß einer Ausführungsform des Verfahrens wird die Vergussmasse mit einer Dispensvorrichtung, insbesondere einer Dispensnadel, in die Aussparung des Gehäuses eingebracht, insbesondere indem zunächst die Dispensvorrichtung in die Aussparung eingeführt wird und anschließend Vergussmasse aus der Dispensvorrichtung abgegeben wird und die Dispensvorrichtung aus der Aussparung herausbewegt wird. Vorteilhaft hieran ist, dass die Vergussmasse in der Regel besonders zuverlässig und schnell eingebracht werden kann. Vorstellbar ist auch, dass die Vergussmasse mittels eines Jetverfahrens (wie z.B. von Tintenstrahldruckern bekannt) in die Aussparung des Gehäuses eingebracht wird.

Gemäß einer Ausführungsform der Gehäusevorrichtung weist der Steckerpin eine Öffnung auf, die zumindest teilweise fluchtend mit der Aussparung des Gehäuses ausgerichtet ist und in der Vergussmasse angeordnet ist. Vorteilhaft hieran ist, dass das Gehäuse typischerweise nur eine einzige Öffnung aufweisen muss und die Vergussmasse dennoch technisch einfach auf beide gegenüberliegende Seiten des Steckerpins gelangt. Somit kann die Gehäusevorrichtung typischerweise technisch besonders einfach und schnell hergestellt werden.

Gemäß einer Ausführungsform der Gehäusevorrichtung weist die Öffnung einen ellipsenförmigen, insbesondere kreisförmigen, oder rechteckigen Querschnitt auf. Hierdurch kann die Öffnung typischerweise technisch einfach hergestellt werden. Zudem weist der Steckerpin in der Regel eine hohe mechanische Belastungsfähigkeit auf.

Gemäß einer Ausführungsform der Gehäusevorrichtung weist die Aussparung eine trichterförmige Form auf, wobei die Aussparung einen kleiner werdenden Durchmesser aufweist, wenn man sich dem Steckerpin nähert.

Es wird darauf hingewiesen, dass einige der möglichen Merkmale und Vorteile der Erfindung hierin mit Bezug auf unterschiedliche Ausführungsformen des Verfahrens zum Abdichten eines Steckerpins in einem Gehäuse bzw. der Gehäusevorrichtung beschrieben sind.

### Kurze Beschreibung der Zeichnungen

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind.
- Fig. 1 zeigt: eine seitliche Querschnittsansicht einer Ausführungsform der erfindungsgemäßen Gehäusevorrichtung;
- Fig. 2 zeigt: eine horizontale Querschnittsansicht der Gehäusevorrichtung aus Fig. 1;
- Fig. 3 zeigt: eine vertikale Querschnittsansicht der Gehäusevorrichtung aus Fig. 1 bzw. Fig. 2.
- Fig. 4: zeigt eine seitliche Querschnittsansicht einer beispielhaften Ausführungsform der Gehäusevorrichtung.

Die Figuren sind lediglich schematisch und nicht maßstabsgetreu. Gleiche Bezugszeichen bezeichnen in den Figuren gleiche oder gleichwirkende Merkmale.

### Ausführungsformen der Erfindung

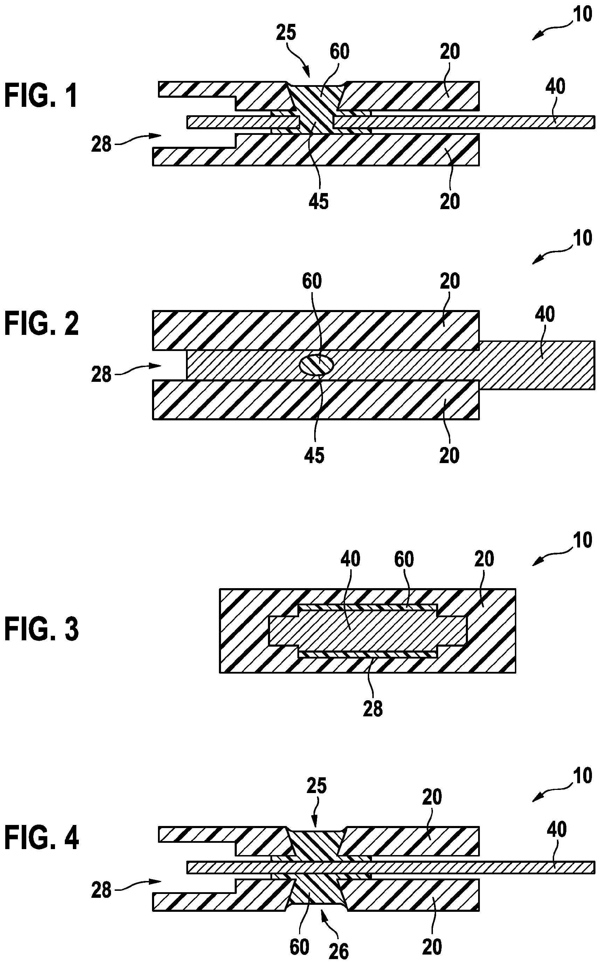

Fig. 1 zeigt eine seitliche Querschnittsansicht einer Ausführungsform der erfindungsgemäßen Gehäusevorrichtung 10. Fig. 2 zeigt eine horizontale Querschnittsansicht der Gehäusevorrichtung 10 aus Fig. 1. Fig. 3 zeigt eine vertikale Querschnittsansicht der Gehäusevorrichtung 10 aus Fig. 1 bzw. Fig. 2.

Die Gehäusevorrichtung 10 umfasst ein Gehäuse 20 und einen Steckerpin 40.

Das Gehäuse 20 umgibt ein Bauelement, z.B. einen Sensor, und schützt das Bauelement vor der Umgebung. Der Steckerpin 40 kann zur elektrischen Verbindung des Bauelements in dem Gehäuse 20 dienen. Dies bedeutet, dass der Steckerpin 40 eine elektrische Verbindung zwischen dem Innenraum des Gehäuses 20 und der Umgebung bildet. Es können auch mehrere Steckerpins 40 vorhanden sein.

Das Gehäuse 20 weist eine Einführöffnung 28 auf, in die der Steckerpin 40 eingeführt bzw. eingeschoben wurde. Der Steckerpin 40 wurde in die Einführrichtung, die in Fig. 1 und in Fig. 2 von links nach rechts verläuft und in Fig. 3 in die Zeichenebene hinein verläuft, in das Gehäuse 20 eingeführt. Wie in Fig. 2 gut zu erkennen, weist der Steckerpin 40 eine größere Breite auf als die Einführöffnung 28 auf. Der Steckerpin 40 berührt bzw. kontaktiert das Gehäuse 20 nur in zwei gegenüberliegenden Randbereichen (in Fig. 2 oben und unten).

Die Einführöffnung 28 weist im vertikalen Querschnitt (siehe Fig. 3) eine Form auf, die zwei mittig übereinander angeordneten Rechtecken entspricht. Das erste Rechteck weist eine größere Breite (die in Fig. 3 von links nach rechts verläuft) auf als das zweite Rechteck. Das zweite Rechteck weist eine größere Höhe (die in Fig. 3 von oben nach unten verläuft) als das erste Rechteck auf. Die Kanten der Rechtecke verlaufen teilweise parallel und teilweise senkrecht zueinander. Der mit der Vergussmasse 60 verschlossene Zwischenraum zwischen dem Steckerpin 40 und dem Gehäuse 20 befindet sich in dem Bereich, der sich oberhalb des ersten Rechtecks und noch in dem zweiten Rechteck befindet, d.h. in einer Schnittfläche des ersten und zweiten Rechtecks.

Es ist auch vorstellbar, dass die Einführöffnung 28 im vertikalen Querschnitt (siehe Fig. 3) eine rechteckige Form aufweist.

Dieses Einführen des Steckerpins 40 zum Bilden eines Formschlusses ist auch als "Stitchen" bekannt. Der Steckerpin 40 ragt in den Innenraum des Gehäuses 20, der sich in Fig. 1 bzw. Fig. 2 nach rechts von dem dargestellten Teil des Gehäuses 20 hin erstreckt. Nach links von dem dargestellten Teil des Gehäuses 20 in Fig. 1 bzw. Fig. 2 erstreckt sich die Umgebung des Gehäuses 20.

Das Gehäuse 20 weist eine Aussparung 25 zum Einbringen des Vergussmaterials auf. Die Aussparung 25 befindet sich, wenn der Steckerpin 40 an die vorgesehene Position (die in den Fig. 1-3 dargestellt ist) bewegt bzw. in die Einführöffnung 28 eingebracht wurde, von den beiden entlang der Einführrichtung gegenüberliegenden Enden des Steckerpins 40, d.h. dem in Fig. 1 bzw. Fig. 2 linken und rechten Enden des Steckerpins 40, entfernt.

Der Steckerpin 40 weist eine Öffnung 45 zum Aufnehmen des Vergussmaterials auf. Die Öffnung 45 ist von den beiden entlang der Einführrichtung gegenüberliegenden Enden, d.h. dem in Fig. 1 bzw. Fig. 2 linken und rechten Enden des Steckerpins 40, entfernt. Die Öffnung 45 kann beispielsweise einen kreisrunden oder rechteckigen Querschnitt aufweisen.

Die Öffnung 45 ist derart ausgebildet bzw. der Steckerpin 40 wird derart tief in die Einführöffnung 28 eingeführt bzw. eingeschoben, dass die Öffnung 45 zumindest teilweise fluchtend mit der Aussparung 25 des Gehäuses 20 angeordnet ist. Dies bedeutet, dass die Aussparung 25 und die Öffnung 45 zumindest teilweise in Fig. 1 übereinander liegen. Vorzugsweise fluchten die Öffnung 45 des Steckerpins 40 und die Aussparung 25 des Gehäuses 20 vollständig. Die Öffnung 45 des Steckerpins 40 und die Aussparung 25 des Gehäuses 20 können den gleichen Querschnitt oder unterschiedliche Querschnitte aufweisen. Vorzugsweise weist die Aussparung 25 des Gehäuses 20 einen größeren Querschnitt auf als die Aussparung 25 des Steckerpins 40. Es ist auch möglich, dass die Öffnung 45 nicht fluchtend zu der Aussparung 25 angeordnet wird, wenn die Vergussmasse eine entsprechend niedrige Viskosität hat.

Nach dem Einbringen des Steckerpins 40 in das Gehäuse 20 bzw. die Einführöffnung 28 wird nun eine flüssige bzw. zähflüssige Vergussmasse 60 in die Aussparung 25 des Gehäuses 20 bzw. in die Öffnung 45 des Steckerpins 40 eingebracht. Die Vergussmasse 60 gelangt durch die Öffnung 45 des Steckerpins 40 auf zwei gegenüberliegenden Seiten des Steckerpins 40 (in Fig. 1 die obere und die untere Seite des Steckerpins 40) und verschließt einen Zwischenraum zwischen dem Steckerpin 40 und dem Gehäuse 20. Anschließend wird das Vergussmaterial ausgehärtet.

Nach dem Aushärten ist der Bereich zwischen dem Steckerpin 40 und dem Gehäuse 20 derart abgedichtet, dass kein Fluid (oder Gas) durch diesen Bereich aus der Umgebung in den Innenraum des Gehäuses 20 gelangen kann bzw. hieraus in die Umgebung austreten kann.

Das Vergussmaterial kann eine Vergussmasse 60, ein Klebstoff, insbesondere ein silikonbasierter Klebstoff, Polyurethan, ein Epoxidharz oder ähnliches sein. Das Aushärten kann z.B. durch Raumtemperaturverfahren, durch schattenhärten Verfahren mit einer Aktivierung durch UV- oder IR-Strahlung durchgeführt werden.

Die Gehäusevorrichtung 10 ist nach Einbringen des Vergussmaterials und dem Aushärten des Vergussmaterials, was nach dem übrigen Verschließen des Innenraums gegenüber der Umgebung stattfinden kann, gegenüber der Umgebung abgedichtet. Durch den Steckerpin 40 besteht eine elektrische Verbindung zwischen dem Innenraum des Gehäuses 20 bzw. einem Bauelement (z.B. Sensor) in dem Innenraum des Gehäuses 20 und der Umgebung.

Die Vergussmasse 60 kann in die Öffnung 45 bzw. Aussparung 25eingebracht werden, indem beispielsweise eine Dispensvorrichtung, z.B. eine Dispensnadel, in die Aussparung 25des Gehäuses 20 und anschließend in die Öffnung 45 des Steckerpins 40 eingeführt wird, bis beispielsweise die Dispensvorrichtung die Seite des Gehäuses 20 berührt, die der Aussparung 25 des Gehäuses 20 direkt gegenüberliegt. Nun wird die Vergussmasse 60 beispielsweise aus der Dispensvorrichtung abgegeben und die Dispensvorrichtung aus der Öffnung 45 und anschließend aus der Aussparung 25bewegt. Diese Bewegung kann während des Ausgebens der Vergussmasse 60 oder abwechselnd mit dem Ausgeben der Vergussmasse 60 stattfinden.

Die Aussparung 25kann eine trichterförmige Form aufweisen, wobei die Aussparung 25kleiner wird, je weiter man sich dem Steckerpin 40 nähert.

Der Steckerpin 40 bzw. der Teil des Steckerpins 40, der später mit Vergussmaterial in Kontakt gerät, kann vorbehandelt werden, um eine verbesserte Verbindung zwischen Vergussmaterial und Steckerpin 40 zu bilden. Hierzu kann z.B. der Teil des Steckerpins 40 mit Schmirgelmaterial angeraut werden, chemisch angeätzt werden und/oder eine Plasmaaktivierung dieses Teils kann durchgeführt werden.

Fig. 4 zeigt eine seitliche Querschnittsansicht eines Beispiels der Gehäusevorrichtung 10.

Das Beispiel unterscheidet sich von der ersten Ausführungsform dadurch , dass der Steckerpin 40 keine Öffnung aufweist und dass das Gehäuse 20 zwei Aussparungen 25, 26 auf zwei gegenüberliegenden Seiten des Steckerpins 40 aufweist.

Da der Steckerpin 40 keine Öffnung aufweist, wird die Vergussmasse 60 in zwei zueinander gegenüberliegenden Aussparungen 25, 26 des Gehäuses 20 eingebracht. Die beiden Aussparungen 25, 26 liegen einander derart gegenüber, dass der Steckerpin 40 sich zwischen den beiden Aussparungen 25, 26 befindet.

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Bezugszeichen in den Ansprüchen sind nicht als Einschränkung anzusehen.

## Patentansprüche

1. Verfahren zum Abdichten eines Steckerpins (40) in einem Gehäuse (20),
wobei das Gehäuse (20) mindestens eine Aussparung (25, 26) zum Abdichten eines Bereichs zwischen dem Steckerpin (40) und dem Gehäuse (20) aufweist,
wobei das Verfahren folgende Schritte umfasst:
Bereitstellen des Gehäuses (20) mit dem Steckerpin (40), wobei der Steckerpin (40) in zwei zueinander gegenüberliegenden entlang einer Einführrichtung verlaufenden Randbereichen des Steckerpins (40) das Gehäuse (20) kontaktiert und in diesen Randbereichen eine formschlüssige Verbindung mit dem Gehäuse (20) bildet;
Einbringen von Vergussmasse (60) in die mindestens eine Aussparung (25, 26) derart, dass die Vergussmasse (60) auf zwei gegenüberliegende Seiten des Steckerpins (40) gelangt, dass die Vergussmasse (60) den Bereich zwischen dem Steckerpin (40) und dem Gehäuse (20), insbesondere flüssigkeitsdicht, vorzugsweise luftdicht, abdichtet; und Aushärten der Vergussmasse (60), **dadurch gekennzeichnet, dass** die Vergussmasse (60) die zwei entlang der Einführrichtung gegenüberliegenden Enden des Steckerpins (40) nicht berührt und der Steckerpin (40) eine Öffnung (45) zum Gelangen der Vergussmasse (60) von einer Seite des Steckerpins (40) auf die andere Seite des Steckerpins (40) aufweist, wobei die Öffnung (45) zumindest teilweise fluchtend mit der Aussparung (25, 26) ausgerichtet ist.

2. Verfahren nach Anspruch 1, wobei
die Öffnung (45) einen ellipsenförmigen, insbesondere kreisförmigen, oder rechteckigen Querschnitt aufweist.

3. Verfahren nach einem der vorhergehenden Ansprüche, wobei
das Gehäuse (20) zwei derart zueinander gegenüberliegende Aussparungen (25, 26) zum Einbringen der Vergussmasse (60) aufweist, dass der Steckerpin (40) zwischen den beiden Aussparungen (25, 26) in dem Gehäuse (20) angeordnet ist.

4. Verfahren nach einem der vorhergehenden Ansprüche, wobei
die Vergussmasse (60) mit einer Dispensvorrichtung, insbesondere einer Dispensnadel, in die Aussparung (25, 26) des Gehäuses (20) eingebracht wird,
insbesondere indem
zunächst die Dispensvorrichtung in die Aussparung (25, 26) eingeführt wird, bis die Dispensvorrichtung durch die Aussparung (25, 26) des Gehäuses (20) gelangt ist und
anschließend Vergussmasse (60) aus der Dispensvorrichtung abgegeben wird und die Dispensvorrichtung aus der Aussparung (25, 26) herausbewegt wird.

5. Gehäusevorrichtung (10) umfassend ein Gehäuse (20) und einen Steckerpin (40),
wobei der Steckerpin (40) in eine Einführöffnung (28) des Gehäuses (20) entlang einer Einführrichtung derart eingeführt ist, dass der Steckerpin (40) in zwei zueinander gegenüberliegenden Randbereichen des Steckerpins (40) das Gehäuse (20) kontaktiert und in diesen Randbereichen eine formschlüssige Verbindung mit dem Gehäuse (20) bildet,
wobei das Gehäuse (20) mindestens eine Aussparung (25, 26) zum Abdichten eines Bereichs zwischen dem Steckerpin (40) und dem Gehäuse (20) aufweist,
wobei in der mindestens einen Aussparung (25, 26) und auf zwei gegenüberliegenden Seiten des Steckerpins (40) Vergussmasse (60) derart angeordnet ist, dass der Bereich zwischen dem Steckerpin (40) und dem Gehäuse (20) flüssigkeitsdicht, insbesondere luftdicht, abgedichtet ist, **dadurch gekennzeichnet, dass** die Vergussmasse (60) die zwei entlang der Einführrichtung gegenüberliegenden Enden des Steckerpins (40) nicht berührt und der Steckerpin (40) eine Öffnung (45) aufweist, die zumindest teilweise fluchtend mit der Aussparung (25, 26) des Gehäuses (20) ausgerichtet ist und in der Vergussmasse (60) angeordnet ist.

6. Gehäusevorrichtung (10) nach Anspruch 5, wobei die Öffnung (45) einen ellipsenförmigen, insbesondere kreisförmigen, oder rechteckigen Querschnitt aufweist.

7. Gehäusevorrichtung (10) nach einem der Ansprüche 5-6, wobei das Gehäuse (20) zwei zueinander gegenüberliegende Aussparungen (25, 26) aufweist, wobei die zwei Aussparungen (25, 26) auf zwei zueinander gegenüberliegenden Seiten des Steckerpins (40) angeordnet sind.

8. Gehäusevorrichtung (10) nach einem der Ansprüche 5-7, wobei die Aussparung (25, 26) oder die Aussparungen (25, 26) eine trichterförmige Form aufweisen, wobei die Aussparung (25, 26) oder die Aussparungen (25, 26) einen kleiner werdenden Durchmesser aufweisen, wenn man sich dem Steckerpin (40) nähert.

## Claims

1. Method for sealing off a plug pin (40) in a housing (20), wherein the housing (20) has at least one cutout (25, 26) for sealing-off of a region between the plug pin (40) and the housing (20),
wherein the method comprises the following steps:
providing the housing (20) with the plug pin (40), wherein the plug pin (40) is in contact with the housing (20) in two mutually oppositely situated edge regions, extending along an insertion direction, of the plug pin (40) and, in said edge regions, forms a form-fitting connection to the housing (20);
introducing potting compound (60) into the at least one cutout (25, 26) in such a way that the potting compound (60) passes to two oppositely situated sides of the plug pin (40) and that the potting compound (60) seals off the region between the plug pin (40) and the housing (20), in particular in a liquid-tight manner, preferably in an air-tight manner; and
curing the potting compound (60), **characterized in that** the potting compound (60) is not in contact with the two ends of the plug pin (40), which are situated oppositely along the insertion direction, and the plug pin (40) has an opening (45) for passage of the potting compound (60) from one side of the plug pin (40) to the other side of the plug pin (40), wherein the opening (45) is oriented so as to be at least partially aligned with the cutout (25, 26).

2. Method according to Claim 1, wherein
the opening (45) has an elliptical, in particular circular, or rectangular cross section.

3. Method according to either of the preceding claims, wherein
the housing (20) has two cutouts (25, 26) for introduction of the potting compound (60) that are situated oppositely in such a way that the plug pin (40) is arranged in the housing (20) between the two cutouts (25, 26).

4. Method according to one of the preceding claims, wherein
the potting compound (60) is introduced into the cutout (25, 26) of the housing (20) by a dispensing device, in particular a dispensing needle,
in particular in that,
firstly, the dispensing device is inserted into the cutout (25, 26) until the dispensing device has passed through the cutout (25, 26) of the housing (20) and, subsequently, potting compound (60) is discharged from the dispensing device and the dispensing device is moved out of the cutout (25, 26).

5. Housing device (10) comprising a housing (20) and a plug pin (40),
wherein the plug pin (40) is inserted into an insertion opening (28) of the housing (20) along an insertion direction in such a way that the plug pin (40) is in contact with the housing (20) in two mutually oppositely situated edge regions of the plug pin (40) and, in said edge regions, forms a form-fitting connection to the housing (20),
wherein the housing (20) has at least one cutout (25, 26) for sealing-off of a region between the plug pin (40) and the housing (20),
wherein potting compound (60) is arranged in the at least one cutout (25, 26) and on two oppositely situated sides of the plug pin (40) in such a way that the region between the plug pin (40) and the housing (20) is sealed off in a liquid-tight manner, in particular in an air-tight manner, **characterized in that** the potting compound (60) is not in contact with the two ends of the plug pin (40), which are situated oppositely along the insertion direction, and the plug pin (40) has an opening (45) which is oriented so as to be at least partially aligned with the cutout (25, 26) of the housing (20) and in which potting compound (60) is arranged.

6. Housing device (10) according to Claim 5, wherein the opening (45) has an elliptical, in particular circular, or rectangular cross section.

7. Housing device (10) according to either of Claims 5 and 6, wherein
the housing (20) has two mutually oppositely situated cutouts (25, 26), wherein the two cutouts (25, 26) are arranged on two mutually oppositely situated sides of the plug pin (40).

8. Housing device (10) according to one of Claims 5-7, wherein
the cutout (25, 26) or the cutouts (25, 26) are of funnelshaped form, and wherein the cutout (25, 26) or the cutouts (25, 26) have a diameter which decreases in size as the plug pin (40) is approached.

## Revendications

1. Procédé d'étanchéification d'une broche de connexion (40) dans un boîtier (20), le boîtier (20) présentant au moins un évidement (25, 26) pour étanchéifier une zone entre la broche de connexion (40) et le boîtier (20),
le procédé comprenant les étapes suivantes :
fourniture du boîtier (20) avec la broche de connexion (40), la broche de connexion (40) étant en contact avec le boîtier (20) dans deux zones de bord de la broche de connexion (40) opposées l'une à l'autre et s'étendant le long d'une direction d'introduction et formant dans ces zones de bord une liaison par complémentarité de forme avec le boîtier (20) ;
introduction d'une masse de scellement (60) dans ledit au moins un évidement (25, 26) de telle sorte que la masse de scellement (60) parvienne sur deux côtés opposés de la broche de connexion (40), de sorte que la masse de scellement (60) rende étanche la zone entre la broche de connexion (40) et le boîtier (20), en particulier de manière étanche aux liquides, de préférence de manière étanche à l'air ; et
durcissement de la masse de scellement (60), **caractérisé en ce que** la masse de scellement (60) ne touche pas les deux extrémités de la broche de connexion (40) opposées le long de la direction d'introduction et **en ce que** la broche de connexion (40) présente une ouverture (45) pour faire passer la masse de scellement (60) d'un côté de la broche de connexion (40) à l'autre côté de la broche de connexion (40), l'ouverture (45) étant orientée au moins partiellement en alignement avec l'évidement (25, 26).

2. Procédé selon la revendication 1, dans lequel l'ouverture (45) présente une section transversale elliptique, notamment circulaire, ou rectangulaire.

3. Procédé selon l'une quelconque des revendications précédentes,
le boîtier (20) présente deux évidements (25, 26) opposés l'un à l'autre pour l'introduction de la masse de scellement (60) de telle sorte que la broche de connexion (40) est disposée entre les deux évidements (25, 26) dans le boîtier (20).

4. Procédé selon l'une quelconque des revendications précédentes,
la masse de scellement (60) est introduite dans l'évidement (25, 26) du boîtier (20) en utilisant un dispositif de distribution, en particulier une aiguille de distribution,
notamment
en introduisant d'abord le dispositif de distribution dans l'évidement (25, 26) jusqu'à ce que le dispositif de distribution soit passé à travers l'évidement (25, 26) du boîtier (20) et
qu'ensuite la masse de scellement (60) soit distribuée par le dispositif de distribution et que le dispositif de distribution soit déplacé hors de l'évidement (25, 26) .

5. Dispositif de boîtier (10) comprenant un boîtier (20) et une broche de connexion (40),
la broche de connexion (40) étant introduite dans une ouverture d'introduction (28) du boîtier (20) le long d'une direction d'introduction de telle sorte que la broche de connexion (40) entre en contact avec le boîtier (20) dans deux zones de bord opposées l'une à l'autre de la broche de connexion (40) et forme dans ces zones de bord une liaison par complémentarité de forme avec le boîtier (20),
le boîtier (20) présentant au moins un évidement (25, 26) pour étanchéifier une zone entre la broche de connexion (40) et le boîtier (20),
une masse de scellement (60) étant disposée dans ledit au moins un évidement (25, 26) et sur deux côtés opposés de la broche de connexion (40) de telle sorte que la zone entre la broche de connexion (40) et le boîtier (20) soit rendue étanche aux liquides, en particulier étanche à l'air ; **caractérisé en ce que** la masse de scellement (60) ne touche pas les deux extrémités de la broche de connexion (40) opposées le long de la direction d'introduction et la broche de connexion (40) présente une ouverture (45) qui est orientée au moins partiellement en alignement avec l'évidement (25, 26) du boîtier (20) et est disposée dans la masse de scellement (60) .

6. Dispositif de boîtier (10) selon la revendication 5, dans lequel
l'ouverture (45) présente une section transversale elliptique, notamment circulaire, ou rectangulaire.

7. Dispositif (10) selon l'une quelconque des revendications 5 à 6,
dans lequel le boîtier (20) présente deux évidements (25, 26) opposés l'un à l'autre, les deux évidements (25, 26) étant disposés sur deux côtés opposés de la broche de connexion (40).

8. Dispositif (10) selon l'une quelconque des revendications 5 à 7,
dans lequel le ou les évidements (25, 26) ont une forme d'entonnoir, le ou les évidements (25, 26) ayant un diamètre qui diminue lorsqu'on s'approche de la broche de connexion(40).
